(19) Europäisches Patentamt European Patent Office Office européen des brevets

(11) **EP 4 617 681 A1**

(12) **EUROPEAN PATENT APPLICATION**

(43) Date of publication:
**17.09.2025 Bulletin 2025/38**

(21) Application number: **24163795.8**

(22) Date of filing: **15.03.2024**

(51) International Patent Classification (IPC):
**G01R 15/24** (2006.01)   **G01K 11/00** (2006.01)
**G01R 33/032** (2006.01)   **G01R 33/26** (2006.01)
**G01N 24/00** (2006.01)   **G01Q 70/14** (2010.01)
**G01R 29/08** (2006.01)

(52) Cooperative Patent Classification (CPC):
**G01R 15/24; G01K 7/36; G01Q 70/14;**
**G01R 29/0878;** G01R 31/311; G01R 31/315;
G01R 33/26

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Qnami AG**
**4132 Muttenz (CH)**

(72) Inventor: **RICKHAUS, Peter**
**4054 Basel (CH)**

(74) Representative: **P&TS SA (AG, Ltd.)**
**Avenue J.-J. Rousseau 4**
**P.O. Box 2848**
**2001 Neuchâtel (CH)**

(54) **HIGH-RESOLUTION SENSING OF LOCAL MAGNETIC FIELDS AND TEMPERATURE IN RF CURRENT CARRYING DEVICES**

(57) The invention concerns a system and a method for non-invasive measurement of a local AC magnetic field and/or a local temperature in an electrically conductive sample structure (300). The system comprises a sensing probe (1) formed of a solid-state lattice with one or more spin defects which are tunable by external magnetic and/or electric fields, an RF transmitting antenna (2) configured to emit RF waves, and a microscope configured to determine and/or control the distance between a sensing surface (15) of the sensing probe and a surface of the electrically conductive sample (300). The RF transmitting antenna (2) is arranged at a distance ($D_{RFT}$) from the surface of the conductive sample structure (300) for contactless induction of electrical RF current flow in the electrically conductive sample structure (300). The RF transmitting antenna (2) is further arranged at a distance ($D_{RFT}$) from the one or more spin defects such that near-field inductive coupling between the RF transmitting antenna (2) and the one or more spin defects is prevented or substantially prevented.

Fig. 2

## Description

### Technical domain

The present invention concerns a testing system and method for high resolution measurement of a local magnetic field and/or a local temperature in a sample structure carrying an RF current.

### Related art

Modern technology in the areas of telecommunications, radar systems and high speed-data communication, relies increasingly on the transmission of high frequency signals transmitted over short distances. Integrated circuits (IC), which typically operate in the radiofrequency (RF) range, are key components for signal transmission, providing high speed as well as low-power data processing.

Specifically, RF carrying IC devices (RF-IC devices) are used in wireless communication devices, such as in mobile phones, in various home appliances, as well as in Internet of Things (IoT) devices. However, testing of alternating current (AC) flow in RF-IC devices remains suboptimal, as measuring electrical current flow in these devices requires wire-bonding and applying an AC current through an IC wire.

Today, a variety of different methods is used to measure the local current flow pattern in conductors. Optical techniques that allow to detect electrical leakage currents for industrial failure analysis applications, such as OBIRCH (Optical Beam Induced Resistivity Change) and EMMI (EMission MIcroscopy) are widely used for this purpose. These techniques achieve a typical spatial resolution of larger than 500nm, and are therefore not suited for imaging in the low nm or the sub-nm range.

Higher current sensitivity is achieved with scanning near field microscopy (SNOM), micro-Brillouin light scattering (BLS), superconducting quantum interference devices (SQUID), atomic vapor cells or ultracold atoms. A widely used technique that provides sub-nm spatial resolution is based on scanning electron microscopy (SEM). However, all of these methods require a hard electrical contact to the device, i.e. the current is supplied through wire bonds, soldered wires, wire-wrapped pins, PCB connectors or microprobes.

Establishing a direct electrical contact, for example through the wire bond, with the IC for testing is not only cumbersome and costly, but the physical interferes with the IC device may also result in inaccurate test results, for example due to defects in the electrical connections, or cause damage to the device. Despite the high demand in RF-IC devices, reliable quality testing of the electrical circuits is therefore still a challenge today.

Diamond nitrogen-vacancy (NV) center magnetometry has emerged in recent years as a technique that can measure local magnetic fields, and consequently current densities, quantitatively, with sub-100 nm spatial resolution and under ambient conditions. Such method has been applied to the sensing of DC and AC currents in hard-wired devices, which require an additional MW delivery antenna to be positioned with the NV center within its ultra-near-field regime, which corresponds to a typical distance of 10 μm and a typical AC field amplitude of $B_{\pm MW}$=100 μT. This increases complexity of the system and introduces spatial inhomogeneities in the MW amplitude due to the nature of the ultra-near-field region of the antenna.

It is therefore highly desirable to find a test method and system to determine electrical current flow in AC carrying IC devices which is less complex than known systems and which does not rely on establishing a physical electrical connection, such as a wire bond, with the IC device.

### Short disclosure of the invention

The invention sets out to overcome the shortcomings and limitations of the state of the art.

It is an aim of the present invention to provide a reliable testing system and/or a method for measuring parameters which allow to determine the local current flow.

It is an aim to provide a reliable high-resolution testing system and/or a method for measuring a local magnetic field in an RF current carrying conductor, such as a wire, a cable or an electronic circuit.

It is another aim of the present invention to provide a reliable high-resolution testing system and/or a method for measuring a local temperature in an RF current carrying conductor.

It is another aim of this invention to provide a measurement system and/or a method for measuring a local magnetic field and/or local temperature in an RF current carrying conductor, which is simpler and less prone to spatial inhomogeneities than similar measurement systems known in the art.

It is yet another aim of this invention to provide an alternative to existing high-resolution measurement systems for local magnetic fields and / or local temperature allowing to determine RF current flow in electrical conductors, in particular in electronic circuits.

According to the invention, one or more of these aims are attained by the object of the attached claims, and especially by the independent claims. The dependent claims provide optional embodiments of the claimed invention.

In particular, one or more of these aims are attained by a system for measuring of a local magnetic field and/or a local temperature in an electrically conductive sample structure, which is provided with a sensing probe formed of a solid-state lattice containing one spin defect or an ensemble of spin defects.

The one or more spin defects are configured to emit fluorescent light upon irradiation with excitation light (L). The energy states of said spin defects is tunable by external magnetic and/or electric fields.

The RF field generated by the RF current flow in the conductive sample structure serves as the MW field required for the manipulation of the spin population of the NV center without the need of an external near-field MW antenna. The RF field generated by the RF current flow may also generate heat within the conductor material, which results in a local increase in temperature of the measured device.

The spin defect or the ensemble of spin defects are configured to undergo a Zeeman shift in energy level upon irradiation with excitation light (L) followed by exposure to a magnetic field. This Zeeman shift may be proportional to the magnetic field strength.

The spin defect or the ensemble of spin defects are configured to undergo a shift in zero-field splitting (D) energy level upon irradiation with excitation light (L) followed by exposure to heat. This shift may be proportional to $c_T = dD/dT = -74.2$ kHz/K within temperature range of 100 K to 600 K.

The system may be adapted to measure local magnetic fields in the electrically conductive sample structure. The system may be adapted to measure local temperature in the electrically conductive sample structure. The system may be suitable for measuring both, local magnetic fields and local temperatures.

On the basis of the measured local AC magnetic field, a local RF amplitude and phase in the electrically conductive sample structure may be determined.

The measurement of the AC magnetic field and temperature in the RF current carrying conductive sample structure provide quantitative and/or qualitative information about the sample structure. Local variations of local AC stray magnetic fields and/or in local temperature indicate altered RF current flows which in turn may be due to irregularities or defects in the conductive sample structure.

The system further comprises a near-field RF transmitting antenna configured to couple RF waves to the conductive sample. The RF transmitting antenna is arranged at a defined distance ($D_1$) from the spin defect or from the ensemble of spin defects of the sensing probe.

The RF transmitting antenna is arranged at a defined distance ($D_{RFT}$) from the nearest region or the coupling site of the conductive sample.

The distance $D_{RFT}$ is dimensioned to allow for contactless induction of electrical RF current flow in the electrically conductive sample structure. Preferably, the RF flow in the sample structure is entirely generated by the RF transmitting antenna.

The system of this invention therefore provides for a non-invasive generation of RF current flow. It also provides for non-invasive measurement of a local temperature and/or a local magnetic field in the sample structure.

The term "non-invasive" as used herein means without establishing a physical electrical contact between the RF transmitting antenna and the conductive sample structure, respectively between the conductive sample structure and the spin defects.

Spin defects can be optically excited by visible light, for example, in the case of NV centres yellow-green laser light or an LED light with wavelength below 575 nm, typically with wavelength of 515 nm or 532 nm.

The excitation light (L) may be emitted by an optical excitation source and directed to the one or more spin defects. The excitation light causes the one or more spin defects to fluoresce.

Upon relaxation, the excited spin defects emit fluorescence light which can for example be detected by an optical detector. The optical detector is configured a photoluminescence (PL) output signal from the sensing probe comprising the spin defect or the ensemble of spin defects. In the case of NV centres a red fluorescent light is emitted.

On the basis of this PL output signal the strength of the local AC magnetic field at the probing position can be determined.

Since the optically detected magnetic resonance (ODMR) spectra of spin defects, and in particular of NV centres, also show temperature-sensitive features, the local temperature may also be determined on the basis of the PL measurements.

The distance between a sensing surface of the sensing probe and a surface of the electrically conductive sample is determined and /or controlled by a microscope.

The microscope may form a mounting system adapted for holding the sensing probe, or the microscope is comprised in a mounting system. The mounting system is configured to permit relative motion between the sensing surface of the sensing probe mounted in the mounting system and the electrically conductive sample surface.

The distance $D_1$ between the RF transmitting antenna and the spin defect or the ensemble of spin defects is dimensioned such that the direct coupling between the RF transmitting antenna and the spin defect or the ensemble of spin defects is prevented or substantially prevented. Coupling is prevented when the minimal Bmw amplitude of interest ($B_{MW\_min}$) measured at the region of interest of the sample is smaller than the $B_{MW}$ without the sample ($B_{MW\_inair}$) when positioned at the same distance D1.

The term "substantially prevented" as used in this context means that the $B_{MW\_min} / B_{MW\_inair}$ is at least 10, preferably 100, 1000, or more. The coupling efficiency in a system in which coupling between the RF transmitting antenna and the spin defect or the ensemble of spin defects is substantially prevented may for example be less than $B_{\pm MW}$ of 100 μT.

The behavior of B and E fields in the near-field region of the RF transmitting antenna is decisive for the minimum distance in which the coupling is prevented or substantially prevented. The near-field coupling can only occur within the near-field region of the transmitting antenna, which is defined by ½π of the RF wavelength. For a frequency in the GHz range, such region is within about 1.6 cm from the RF transmitting antenna. From a practical perspective, however, an efficient coupling needed to drive the spin defect or ensemble of spin defects can only occur within the first hundreds of micrometers from the RF transmitting antenna due to the B and E strength decaying with the inverse cube of the distance.

The efficiency of the coupling is given by $B_{\pm MW}$, the (right-) left-handed circularly polarized component of the RF field in a plane perpendicular to the NV axis. An efficient coupling typically occurs at $B_{\pm MW} = 100\ \mu T$, but requires $B_{\pm MW} > 1\ \mu T$.

On the same grounds, the distance $D_{RFT}$ between the RF transmitting antenna and the nearest region or the coupling site of the conductive sample is dimensioned such that the direct coupling between the RF transmitting antenna and the conductive sample dominates. Such distance must not be zero and within the near-field region of the RF transmitting antenna to permit contactless induction of electrical current flow in the electrically conductive sample structure.

In one embodiment of this invention the RF field amplitude $B_{\pm MW}$ between the RF transmitting antenna and the spin defect or the ensemble of spin defects without the presence of the device under investigation is less than $1\mu T$, less than 100nT, 10nT, 1nT.

In one embodiment of this invention, the distance D, between the RF transmitting antenna and the spin defect or the ensemble of spin defects is more than $500\ \mu m$, at least $600\ \mu m$, at least $800\ \mu m$, at least 1mm, at least 10 mm, at least 100 mm, or at least 1cm.

To achieve a sufficient magnetic strength of the AC stray magnetic fields generated by the conductive sample structure , the distance $D_{RFT}$ between the RF transmitting antenna and the conductive sample structure is preferably no more than 100 mm, or no more than 10 mm, no more than 1 mm, no more than 100 $\mu m$, no more than 10 $\mu m$, or no more than 1 $\mu m$.

The maximum distance of $D_1$ is not particularly limited. Since the RF transmitting antenna must be positioned in proximity of the conductive sample structure at a distance $D_{RFT}$ to allow for inductive near field coupling, the maximum distance $D_1$ is determined by the length of the conductive sample structure, respectively by the distance between most removed end of the sample structure and the position of the sensor probe.

Ideally, the minimum distance of $D_1$ should be selected to minimize any electromagnetic interference of the RF transmitting antenna with the one or more spin defects in the sensor probe. For this reason, it is preferable to select a distance $D_1$ of more than 500 $\mu m$. Better even, if the minimum distance of $D_1$ is 600 $\mu m$, 800 $\mu m$, or 1mm or more. By increasing the distance, the interference of the RF transmitting antenna in the magnetometry measurements is reduced, such that the obtained measurements are more accurate.

In a one embodiment the RF transmitting antenna generates frequencies which fall primarily within the microwave (MW) range.

The RF transmitting antenna may generate one or more electromagnetic frequency ranging from 500 MHz to 84 GHz, or from 500MHz to 50 GHz, or from 2.5 GHz to 3.5 GHz, for example 2.87 GHz.

The RF transmitting antenna induces an RF current flow in the conductive sample structure. The sensing probe with one or more spin centers is configured to measure the AC magnetic field resulting from a local current flow in the conductive sample structure.

The conductive sample structure may be a conductive line, a wire, a cable, an electrical circuit, or an integrated circuit (IC). The conductive sample structure is at least partially conductive, it may by a non-conductive material, such silicon, with a conductive region, which may be the result of a change in dopant concentration.

The conductive sample structure may be comprised in a semiconductor chip, a wafer, an electrically contacted 2D material, or a ferromagnetic sensor with a ferromagnetic resonance.

Suitable 2D materials comprise graphene metal dichalcogenides, such as like molybdenum disulfide (MoS2), metal trichalcogenides, metal oxides, phosphorene, MXenes (Silicene, Germanene etc.), metal hallides, metal carbides, and phosphorene.

The invention the spin defect or the ensemble of spin defects may be located no more than 50 nm, no more than 100 nm, no more than 300 nm, or no more than 500 nm, or no more than 2 $\mu m$ from the sensing surface of the sensing probe. For magnetometry measurements, a depth in the lower range should be selected, if a high spatial imaging resolution, for example a spatial resolution between 10nm and 50nm, is desirable. For magnetometry measurements, the closer the one or more spin centres located in respect of the sensing surface, the higher the imaging spatial resolution.

The depth of one or more spin centres is less critical for thermometry measurements. For these measurements the spin defect or the ensemble of spin defects may be located up to 5 $\mu m$ from the sensing surface of the sensing probe or be distributed over the entire volume of the sensing probe.

In one possible embodiment of this invention the sensor probe is arranged such that its sensing surface contacts the surface of the conductive sample structure.

In alternative embodiment the distance $D_{NV}$ between the sensing surface of the sensing probe and the conductive sample structure is less than 1 $\mu m$, less than 10 $\mu m$, or less than 100 $\mu m$.

The solid-state lattice may be a diamond lattice.

The spin defect of the ensemble of spin defects may be NV- centres. The designations "NV" and "NV⁻" are used synonymously herein.

It is however also possible to provide different solid-state lattices and spin defects. Solid state lattices with spin defects that can be spin-polarized upon irradiation with excitation light may be selected. The solid-state lattice may be a rare-earth doped crystal. The solid-state lattice may be SiC. The one or more spin defects may for example be SiV or GeV.

In one embodiment of this invention the RF transmitting antenna carries more than one frequency. At least one of the frequencies emitted by the RF transmitting antenna is configured to induce an RF current in the conductive sample structure. One or more of the other frequencies emitted by the RF transmitting antenna of this embodiment may be configured to modify the other physical parameters of the sample structure. Such physical parameters may for example be the temperature of the noise carried in the conductive sample structure. In other words, the other frequencies may for example be used to increase the temperature or the noise in the conductive sample structure.

An RF antenna may for example emit an RF signal at 2 GHz for inducing RF current flow in the conductive sample structure and a second RF signal at 10 GHz for generating a ferromagnetic resonance in the conductive sample structure.

Sensing probes containing spin defects are also used in high-resolution thermometry. In particular NV sensing probes are known for their ability to monitor sub-Kelvin variations over a large range of temperatures. In addition to monitoring the magnetic field distribution of the electromagnetic fields and stray fields generated in the conductive sample structure, the sensing probes may therefore also be used to detect changes in local temperature in the structure, for example following heating of the structure using a frequency emitted by the RF transmitting antenna.

A second RF signal, for example at 10 GHz, may couple to a system-specific resonance, for example a ferromagnetic resonance or a surface acoustic wave, which, in turn, may influence the NV center and can thus be sensed.

The microscope provided with the system of this invention may be a scanning microscope, for example an atomic force microscope (AFM), a confocal microscope, or a wide field microscope.

This invention also concerns a method for non-invasive measurement of local AC magnetic fields and/or the local temperature of an electrically conductive sample structure using the system described above. The local RF flow through the sample structure on the basis of this measurement.

In the method of this invention the electrical current flow through the electrically conductive sample is caused and/or driven by the RF transmitting antenna.

In one embodiment of this invention, the electrical current flow in the sample structure is entirely driven by the RF transmitting antenna.

In one embodiment of this invention the sensing surface of the sensing probe is positioned at a series of consecutive probing positions in proximity of the electrically conductive sample structure, such as to perform a scan of at least a portion of the sample structure. Measurements are taken at the consecutive positions such as to obtain information about the spatial distribution of the AC magnetic field, the temperature and/or the current flow.

The invention allows for non-invasive quantitative and/or qualitative measurements of AC current flowing in the conductive sample structure.

The invention also allows for non-invasive temperature measurements, for example by providing or adding a frequency tone to the electromagnetic wave emitted by the RF transmitting antenna, which generates heat in the conductive sample structure, or simply by detecting Ohmic heat.

In this case, the frequency of the AC current may be tuned in such way that it generates an AC magnetic field with a frequency outside of the detection bandwidth of conventional ODMR (>10 kHz for CW and >100 kHz for pulsed), or off-resonance from the actual resonance frequency(ies) of the NV centre resulting purely in a temperature signal. This temperature signal may be detected by the sensing probe containing spin defects with temperature-sensitive features.

In one embodiment of this invention, RF pulses are applied to the electrically conductive sample structure by the RF transmitting antenna.

The electrically conductive sample structure may be an IC or a conductive member comprised in a semiconductor chip, a wafer, an electrically contacted 2D material, or a ferromagnetic sensor with a ferromagnetic resonance.

In a preferred embodiment, the measurements using this system are performed under ambient conditions.

With respect to what is known in the art, the invention provides the advantage that the RF transmitting antenna is arranged to induce RF current flow in the conductive sample structure, which as a result acts itself as a RF transmitting antenna in respect of the sensing probe positioned in proximity of the sample structure. The system does therefore not require that an antenna is precisely positioned for manipulating the one or more spin defects. System complexity and performance variation over time due to relative motion between the MW source and the sensing probe are thereby avoided.

Instead, this system allows for measuring AC currents flowing through a conductive sample structure without the need for wire bonding. Specifically, the RF transmitting antenna may be positioned at any large distance from the sensor probe, provided it is positioned to inductively couple with the conductive sample structure. Moreover, the RF transmitting antenna does not have to be moved with the sensing probe, if a series of subsequent local measurements are taken, for example when scanning of the sample structure. Spatial inhomogeneities in the MW amplitude due to a need to position an RF transmitting antenna such that the spin centres are in its near-field regime, as known in the state of the art, are thereby avoided. The system is also less complex than these conventional systems. It therefore provides for more reliable measurements of local AC magnetic fields.

Since the testing of the sample structure is performed wirelessly, without establishing a physical electrical contact with the sample structure to be tested, tests can be performed earlier in the fabrication process of the sample structure as soon as a portion of the sample structure, which is suitable for carrying the RF current flow, is provided. The structure for testing does not have to be provided for specific electrical contact or bonding portions. The early testing of samples in fabrication allows to reject defective samples early, and/or to identify defects in the fabrication process, thus leading to further cost savings.

Due to the contactless nature of the RF excitation of the conductive sample and non-invasiveness of the measurement technique, encapsulated materials can also be excited and measured without the need for exposing the conducting material to ambient conditions. Such modality is of particular relevance in the field of 2D materials.

Furthermore, it allows to measure RF properties of integrated circuits or MRAM devices in their encapsulated state, where the layers are protected from oxidation. The ability to measure in an encapsulated state furthermore facilitates IC testing for failure analysis.

Also, since no physical electrical connection needs to be established for testing of the conducive sample structure, testing is significantly simplified. Repeated measurements of the sample structure throughout its fabrication process may therefore readily be performed.

As a result of the early and/or repeated testing of the conductive sample structure during fabrication, the reliability of the end product is greatly improved and fabrication issues can be detected in a much earlier phase allowing for significant cost and time savings in wafer/device production.

**Short description of the drawings**

Exemplar embodiments of the invention are disclosed in the description and illustrated by the drawings in which:

Figure 1 illustrates schematically a standard arrangement known in the art for DC and AC current and temperature sensing in Scanning NV microscopy (SNVM);

Figure 2 illustrates schematically components of a possible embodiment of a non-invasive sensing system according to this invention;

Figure 3A shows a map of an AC component of a circular polarized conductive sample structure measured according to this invention, with the AC magnetic field $B_{MW}$ shown as a function of x and y position of the sensing probe;

Figure 3B is a graph presenting relation between the distance $D_{NV}$, which is the distance between sensing probe, and the circular polarized component of an AC magnetic field $B_{MW}$ of the conductive sample structure; and

Figure 4 show $B_{MW}$ measurements as a function of the distance D1 between the antenna and the spin defect when microwave power is applied for directly driving the NV centres without the sample structure.

**Examples of embodiments of the present invention.**

The present invention concerns a set-up which permits determining of AC current flow through the conductor wirelessly, without establishing any physical electrical contact with the conductor. The AC current in the conductor is generated non-invasively. Importantly, the AC current frequency can be changed such as to perform ODMR measurements, drive specific transitions of the spin defect energy levels or drive a resonance, for example a ferromagnetic resonance, in the sample of interest.

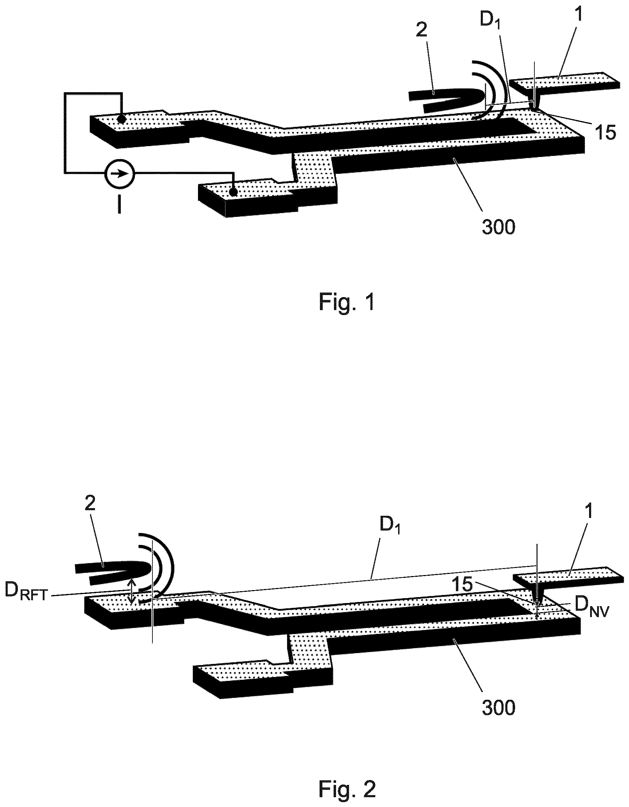

A conventional setup for measuring DC or AC currents in conductive structures using spin resonance magnetometry, for example SNVM, is depicted in Figure 1. In this setup a DC or an AC current is passed through the conductive sample structure 300, for example an electrically conductive loop as shown in this Figure. The current flow in the conductive structure 300 gives rise to a DC or AC magnetic field which is detected by the sensing probe 1, for example an NV sensing probe as shown in this Figure 1. Further, the current flow may also generate heat that can be detected by the sensing probe 1.

In AC as well as in DC magnetic field sensing, a spin defect, for example an NV centre, needs to be driven with a right or left hand circularly polarized component of an AC microwave (MW) field $B_{MW}$. For this purpose, an antenna is provided to generate $B_{MW}$.

In the conventional setup, as shown in Figure 1, a microwave (MW) near-field antenna 2 is positioned in close proximity to the sensing probe, such as to manipulate the spin sub-levels of the spin defects, e.g. the one or more NV centres. The antenna is positioned sufficiently close for the near field component of the MW field to impact the number of photons emitted by said NV centres when in resonance with said spin sub-levels, constituting an ODMR spectrum. For this reason, the antenna 2 is typically arranged at distance $D_1$ from the spin defects or ensemble of spin defects of 400 $\mu$m or less.

The ODMR spectra of NV centres also show temperature-sensitive features with the NV center zero-field splitting energy (D) presenting a temperature dependency.

Figure 2 depicts a setup for non-invasive, contactless measurement of AC current flow in the conductive structure according to this invention. Different from the conventional setup shown in Figure 1, the antenna 2 is positioned at a larger distance $D_1$ from the spin defect or ensemble of spin defects. Distance $D_1$ is sufficiently large to prevent that the near-field coupling of the MW the antenna significantly interferes with the near-field inductive coupling between the RF current carrying conductive sample structure and the spin defects.

The antenna 2 is positioned at distance D1 such that it does not significantly affect the ODMR resonance of the spin defects in the sensing probe.

The antenna is arranged in close proximity at a distance $D_{RFT}$ from the electrically conductive sample structure without touching the conductive sample structure while keeping the conductive sample within its near-field region.

The distance $D_{RFT}$ is such that the electromagnetic near field of the RF antenna inductively generates an electrical current flow in the conductive sample structure. In other words, the distance $D_{RFT}$ allows the RF transmitting antenna to inductively couple with the conductive sample structure.

The induced RF current in the conductive sample structure generates an AC magnetic field $B_{MW}$ in the structure. This magnetic field $B_{MW}$ is suited for driving the spin defects in the solid-state lattice.

The conductive sample structure may take different shapes. Preferably the sample structure is provided in the shape of a wire having a cross-sectional dimension in the nm to $\mu$m range, for example a cross-sectional dimension of 5nm to 10$\mu$m.

Concretely, the generated magnetic field $B_{MW}$ manipulates sub-levels of the spin defects, thereby altering the ODMR spectrum of the spin defects, for example NV centres.

Inhomogeneities in the measured magnetic field $B_{MW}$ are indicative of local alterations of RF current flow in the conductive sample structure. These local alterations may be caused by a defect in the sample structure. The local alterations may also be caused by structural inhomogeneities in the sample structure, or by domain walls or by a resonance in the system, such as a ferromagnetic resonance.

The distance $D_{RFT}$ between the antenna 2 and the conductive sample structure 300 should be no more than 100 mm, or no more than 10 mm, no more than 1 mm, no more than 100 $\mu$m, no more than 10 $\mu$m, or no more than 1 $\mu$m.

With regards to the dimension of distance D1, it is possible to position the antenna 2 as close as 100 $\mu$m from the spin defects. However, at this distance, the electromagnetic waves emitted by the antenna are capable of manipulating the spin defects, which interferes ODMR resonance driven by the near-field inductive coupling between the conductive sample structure and the spin defects. In other words, placing the antenna at a relatively close distance of 100 $\mu$m results in an overlap of the electromagnetic waves emitted by the antenna with the electromagnetic wave emitted by the conductive sample structure. As a consequence, the measurement contains mixed information from direct driving with the antenna and indirect driving with the sample. The information of interest is solely the indirect driving provided by the sample. It is therefore preferred to position the antenna 2 at a larger distance $D_1$ from the spin defects.

To overcome this interference, the antenna 2 should be positioned at a distance D1 of more than 500 $\mu$m, at least 600 $\mu$m, at least 800 $\mu$m, at least 1mm, at least 10 mm, at least 100 mm, or at least 1cm from the spin defect or the ensemble of spin defects.

There is no particular limitation regarding the maximal distance $D_1$, provided the antenna 2 is positioned at a distance $D_{RFT}$ from the conductive sample structure 300 and provided the conductive sample structure is positioned at a distance $D_{NV}$ from the spin defect or the ensemble of spin defect, whereby $D_{NV}$ is sufficiently short to allow for near field coupling between the electromagnetic field generated in the conductive sample structure and the one or more spin defects.

$D_{NV}$ may for example be chosen, such that the sensing surface 15 of the sensor probe 1 contacts the surface of the conductive sample structure 300.

$D_{NV}$ between the sensing surface 15 of the sensing probe and the conductive sample structure may be less than 1 $\mu$m, less than 10 $\mu$m, or less than 100 $\mu$m.

Distances $D_{NV}$ of more than 100 $\mu$m are less suited for measuring AC magnetic fields in the low $\mu$Tesla range due to sensitivity and spatial resolution loss of the system at these distances.

In the setup of this invention, a change of distance $D_{NV}$ has by far the greatest impact on the magnetic field $B_{MW}$ generated by the conductive sample structure. For temperature measurements, $D_{NV}$ plays a critical role as the heat exchange between the sample and sensor is only possible when the two are in contact or in nanometric close proximity. Changes in $D_{RFT}$ has only a minor effect on $B_{MW}$, while changes in $D_1$ generally do not impact $B_{MW}$.

Since distance D1, once it is larger than a minimum distance, does not impact on the measurements, it may be chosen freely to suit the sample structure, or the ease of operations. For example, the user may decide to let the antenna hover over a bonding pad. In this case, D1 is given by the distance between the region of interest measured by the NV center and the bonding pad.

When scanning the sample structure, the repositioning of the sensing probe 1 in respect of the surface of the conductive sample structure 300 will shift the spin defects of ensemble of spin defects thus allowing to locally map magnetic stray fields $B_{MW}$, or other parameters, such as local temperature. Since changes in a $D_{RFT}$ and $D_1$ do not significantly impact the measurements, accurate measurements are obtained when moving the sensing probe 1 through different probing positions for as long as the distance $D_{NV}$ between the sensing surface 15 of the sensing probe and the surface of the conductive sample structure is maintained constant.

For example, in a typical setup $D_1$ may be 1 mm, $D_{RFT}$ may be 10 $\mu$m and $D_{NV}$ may be 50nm. A change in the stated distances by 1 $\mu$m results in a reduction of $B_{MW}$ by 90% if only $D_{NV}$ is changed, a reduction of $B_{MW}$ by 0.1% if only $D_{RFT}$ is changed, or in no reduction at all if $D_1$ is changed.

The impact of a change in the distances mentioned above in an AC carrying sample structure is very different from a DC carrying conductive sample structure. In the latter, $B_{MW}$ quickly decreases with an increase in distance between the RF emitting antenna and the one or more spin centres, i.e. if distance D1 increases. The setup of this invention is suited for measuring AC magnetic fields, but not suitable for measuring DC magnetic fields, as DC currents cannot be inductively generated in a sample structure.

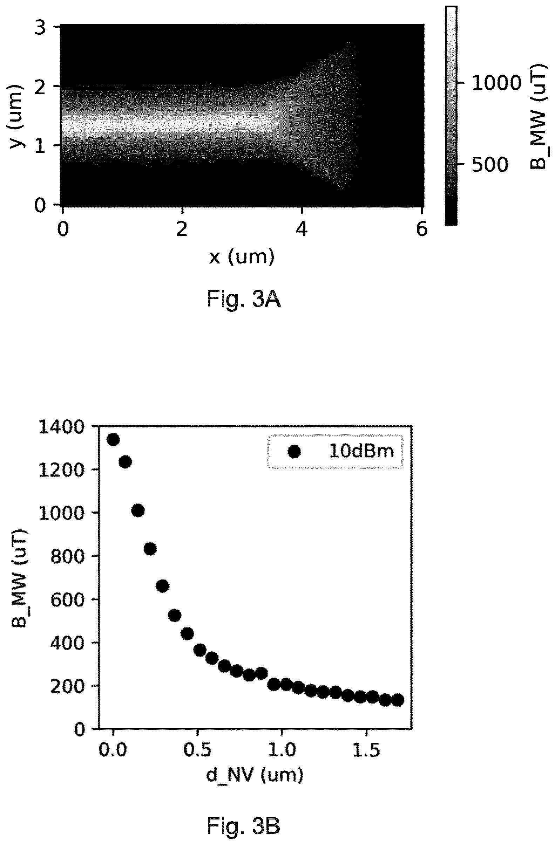

Measurements obtained with a system and method according to this invention are shown in Figure 3A. This Figure shows a map of the AC circular polarized component of a scan performed on a conductive sample structure. The current flow in the structure was induced by the RF antenna 2 according to this invention.

The measurement shown in Figure 3A were obtained using a system according to this invention with the following setup: an RF antenna was hovering over a bonding pad at a distance of $D_1$ = 1mm from the NV center, and at a distance $D_{RFT}$ = 10um. The NV center flying distance was 50nm. The scanned sample structure was a gold wire, Ti/Au of 5/50nm thickness. The sample structure exhibited a constriction in the scanning area, i.e. the wire width is 100nm on the left side of the plot (x=0-3.5um) and increases in width on the right side, for x>3.5um, until reaching a width of 5um. The data were obtained at an RF frequency of 2.8GHz with a single-NV center in the Qnami ProteusQ scanning NV system in a pulsed Rabi scan.

Figure 3B depicts the dependence on the detected magnetic field strength $B_{MW}$ in dependence of distance $D_{NV}$, the distance between the sensing surface 15 of the sensing probe and the conductive sample structure 300. The shown data was obtained at an RF frequency of 2.8GHz with a single-NV center in the Qnami ProteusQ scanning NV system in a pulsed Rabi scan.

The strength of the AC magnetic field was measured by Rabi oscillations, as described in P. Apple et al., Nanoscale microwave imaging with a single electron spin in diamond, New Journal of Physics 17, 112001 (2015).:

$$\frac{\Omega_\pm}{2\pi} = \gamma_{NV} B_{\pm MW}$$

With $\Omega_\pm$ the Rabi frequency, and $B_{\pm MW}$ is the (right-) left-handed circularly polarized component of the MW field in a plane perpendicular to the NV axis.

Good values with optimal sensitivity for typical measurement protocols are:

- Continuous wave ODMR measurements: $B_{\pm MW}$=100uT

- Pulsed ODMR measurements: $B_{\pm MW}$=20uT

- Ramsey measurements: $B_{\pm MW}$=500uT

The measurements show the change in circular polarized component of an AC magnetic field $B_{MW}$ with increasing distance $D_{NV}$ of a sensing probe with a single NV centre to the gold wire, with a $D_1$ of 1900 $\mu$m and $D_{RFT}$ of 300 $\mu$m. The applied power to the antenna was 10 dBm, corresponding to 10mW.

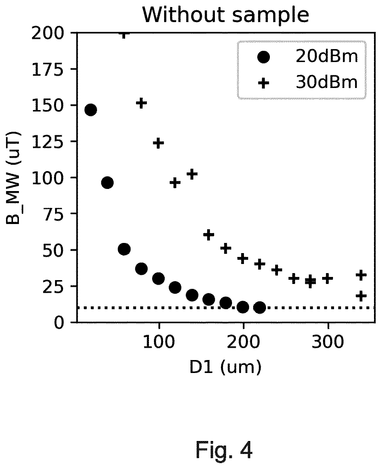

The measurement in Figure 4 serves as a comparison and demonstrates that, despite applying higher microwave power of 20dBm and 30dBm, respectively, direct driving of the NV center without the sample is (i) weaker at the minimal applicable distances, compared to the data shown in Fig3B when a sample is involved, (ii) changes less by changing the distance $D_1$ compared to the situation where a sample is involved and the distance $D_{NV}$ is changed, and (iii) is strongly suppressed at distances >300$\mu$m. Here, it is considered that the antenna cannot be put in direct contact with the NV center, thus leading to a minimum distance $D_1$ of 10$\mu$m, due to risk of breaking the NV tip by mechanical vibrations. The data is taken with a single NV center in the ProteusQ scanning NV system, without the presence of a sample ("in air"), by measuring the Rabi frequency as a function of NV to antenna distance $D_1$. The applied RF frequency is 2.8GHz.

The results shown in Figures 3A and 3B clearly demonstrate that the system according to this invention is suited for non-invasive detection of magnetic stray fields in the sub-mT range arising from RF currents flowing through a conductive sample structure.

As evidenced in Figure 3B, a drastic decrease in signal of the system was observed with an increasing distance $D_{NV}$. In particular at distances $D_{NV}$ of less than 1 $\mu$m even an minor increase in the distance by 5 nm to 10 nm resulted in a significant loss in signal, of up to several hundreds of $\mu$T.

When the distances of either the RF antenna in respect of the gold wire $D_{RFT}$ or in respect of the sensing probe $D_1$ were varied by $\pm$ 2 $\mu$m, no change in the measured $B_{MW}$ field strength was detected.

**Claims**

1. A system for non-invasive measurement of a local AC magnetic field and/or a local temperature in an electrically conductive sample structure (300), comprising

- a sensing probe (1) formed of a solid-state lattice comprising one spin defect or an ensemble of spin defects configured to emit fluorescent light upon irradiation with excitation light, the energy states of said spin defects being tunable by external magnetic and/or electric fields;
- an RF transmitting antenna (2) configured to generate RF waves, said RF transmitting antenna (2) being arranged at a defined distance ($D_1$) from the spin defect or from the ensemble of spin defects of the sensing probe (1),
- a microscope configured to determine and/or control the distance between a sensing surface (15) of the sensing probe and a surface of the electrically conductive sample (300),
wherein the distance ($D_1$) between the RF transmitting antenna (2) and the spin defect or the ensemble of spin defects is dimensioned such that near-field inductive coupling between the RF transmitting antenna (2) and the spin defect or the ensemble of spin defects is prevented or substantially prevented, and
wherein the RF transmitting antenna (2) is arranged at a distance ($D_{RFT}$) from the surface of the conductive sample structure (300) for contactless induction of electrical RF current flow in the electrically conductive sample structure (300).

2. The system of claim 1, wherein the distance ($D_1$) between the RF transmitting antenna (2) and the spin defect or the ensemble of spin defects no less than more than 500 $\mu$m, at least 1mm, at least 10 mm, at least 100 mm, or at least 1cm.

3. The system of any of claims 1 or 2, wherein the distance ($D_{RFT}$) between the RF transmitting antenna (2) and the conductive sample structure (300) is no more than 100 mm, or no more than 10 mm, no more than 1 mm, no more than 100 $\mu$m, no more than 10 $\mu$m, or no more than 1 $\mu$m.

4. The system of any of claims 1 to 3, wherein the sensing surface (15) of the sensing probe contacts the surface of the conductive sample structure (300), or wherein the distance ($D_{NV}$) between the sensing surface (15) of the sensing probe and the conductive sample structure (300) is less than 100 $\mu$m, less than 10 $\mu$m, or less than 1 $\mu$m.

5. The system of any of claims 1 to 4, wherein the solid-state lattice is a diamond lattice.

6. The system of any of claims 1 to 5, wherein spin defect of the ensemble of spin defects are NV⁻ centres.

7. The system of any of claims 1 to 6, said spin defect or ensemble of spin defects being located no more than 50nm, no more than 100 nm, no more than 300nm, or no more than 500nm, no more than 5$\mu$m from the sensing surface (15) of the sensing probe.

8. The system of any of claims 1 to 7, wherein the RF transmitting antenna (2) is configured to emit a frequency ranging from 500 MHz to 84 GHz, or 2.5 GHz to 3.5 GHz, for example 2.87 GHz.

9. The system of any of claims 1 to 8, wherein the RF transmitting antenna (2) carries more than one frequency, wherein a first frequencies is configured to induce an electromagnetic current in the conductive sample structure for generating an AC microwave field, and wherein at least one other frequency is configured to modify the sample structure (300), for example by increasing the temperature of the conductive sample structure and/or generating noise in the conductive sample structure.

10. The system of any of claims 1 to 9, wherein the microscope is a scanning microscope, for example an atomic force microscope (AFM), a confocal microscope, or a wide field microscope.

11. Use of the system of any of claims 1 to 10 for non-invasive imaging of local RF magnetic fields and/or local temperatures in an electrically conductive sample structure (300).

12. A method for non-invasive measurement of a local AC magnetic field and/ or a local temperature in an electrically conductive sample structure (300) comprising

- positioning a sensing surface (15) of a sensing probe (1) formed of a solid-state lattice comprising one spin defect or an ensemble of spin defects, said one spin defect or ensemble of spin defects being configured to emit fluorescent light upon irradiation with excitation light, at a first probing position at a distance ($D_{NV}$) of the electrically conductive sample structure, such as to allow for relative motion between the electrically conductive sample structure (300) and the sensing surface (15);
- positioning an RF transmitting antenna (2)

(i) at a first defined distance ($D_1$) between to the spin defect or the ensemble of spin defects, said first defined distance ($D_1$) being dimensioned such that near-field coupling between the RF transmitting antenna and the spin defect or the ensemble of spin defects is prevented or substantially prevented, and

(ii) at a second defined distance ($D_{RFT}$) to the electrically conductive sample structure, said second defined distance ($D_{RFT}$) being dimensioned such that the RF emitted from the RF transmitting antenna (2) induces electrical RF current flow in the electrically conductive sample structure (300).

- operating the RF transmitting antenna (2) to expose the electrically conductive sample structure (300) to RF radiation thereby inducing and/or driving electrical RF current flow in the electrically conductive sample structure (300) giving rise to a magnetic field $B_{MW}$;
- irradiating the spin defect or the ensemble of spin defects by applying optical radiation with excitation light,
- detecting a photoluminescence (PL) output signal from the sensing probe comprising the spin defect or the ensemble of spin defects and determining the strength of the local AC magnetic field and/or the temperature at the probing position on the basis of said PL output signal,

wherein the electrical current flow through the electrically conductive sample structure (300) is caused and driven by the RF transmitting antenna (2).

13. The method of claim 12, further comprising the step of determining the local RF current flow on the basis of the strength of the AC magnetic field and/or the temperature at the probing position.

14. The method of claim 12 or 13, further comprising positioning the sensing surface (15) of the sensing probe at a series of consecutive probing positions in proximity of the electrically conductive sample structure (300) and performing the method of claim 12 at each of the probing positions such as to obtain information on the AC magnetic field spatial distribution and/or the temperature spatial distribution.

15. The method of any of claims 12 to 14, wherein the RF transmitting antenna (2) emits a frequency in the range of 500 MHz to 84 GHz, or of 2.5 GHz to 3.5 GHz, for example 2.87 GHz.

16. The method of any of claims 12 to 15, wherein a sequence of RF pulses is applied to the electrically conductive sample structure by the RF transmitting antenna (2).

17. The method of any of claims 12 to 16, wherein the electrically conductive sample structure is an integrated circuit (IC) or a conductive member comprised in a semiconductor chip, a wafer, an electrically contacted 2D material, or a ferromagnetic sensor with a ferromagnetic resonance.

Fig. 1

Fig. 2

Fig. 3A

Fig. 3B

Fig. 4

Europäisches
Patentamt

European
Patent Office

Office européen
des brevets

## EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2023/266174 A1 (MUNSCH MATHIEU [FR] ET AL) 24 August 2023 (2023-08-24) * paragraphs [0045] - [0074]; claims 1-35; figures 1-4 * | 1-17 | INV.<br>G01R15/24<br>G01K11/00<br>G01R33/032<br>G01R33/26 |
| A | US 2016/282427 A1 (HEIDMANN JUERGEN [US]) 29 September 2016 (2016-09-29) * paragraphs [0058] - [0161]; claims 1-49; figures 1-41 * | 1-17 | G01N24/00<br>G01Q70/14<br>G01R29/08 |
| A | US 2022/349964 A1 (MIZUOCHI NORIKAZU [JP] ET AL) 3 November 2022 (2022-11-03) * paragraphs [0070] - [0151]; claims 1-12; figures 1-14 * | 1-17 | |
| A | KR 2024 0028534 A (QNAMI AG [CH]) 5 March 2024 (2024-03-05) * paragraphs [0074] - [0118]; claims 1-17; figures 1a-3c * | 1-17 | |

|  | TECHNICAL FIELDS SEARCHED (IPC) |
|---|---|
|  | G01R<br>G01W<br>G01K<br>G01N<br>G01Q |

The present search report has been drawn up for all claims

| Place of search | Date of completion of the search | Examiner |
|---|---|---|
| Munich | 6 August 2024 | Bilzer, Claus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 16 3795

This annex lists the patent family members relating to the patent documents cited in the above-mentioned European search report.
The members are as contained in the European Patent Office EDP file on
The European Patent Office is in no way liable for these particulars which are merely given for the purpose of information.

06-08-2024

| Patent document cited in search report | | Publication date | Patent family member(s) | | Publication date |
|---|---|---|---|---|---|
| US 2023266174 | A1 | 24-08-2023 | CN | 116324353 A | 23-06-2023 |
| | | | EP | 3951339 A1 | 09-02-2022 |
| | | | JP | 7513765 B2 | 09-07-2024 |
| | | | JP | 2023540421 A | 25-09-2023 |
| | | | US | 2023266174 A1 | 24-08-2023 |
| | | | WO | 2022029522 A1 | 10-02-2022 |
| US 2016282427 | A1 | 29-09-2016 | NONE | | |
| US 2022349964 | A1 | 03-11-2022 | JP | 7509379 B2 | 02-07-2024 |
| | | | JP | WO2021054141 A1 | 25-03-2021 |
| | | | US | 2022349964 A1 | 03-11-2022 |
| | | | WO | 2021054141 A1 | 25-03-2021 |
| KR 20240028534 | A | 05-03-2024 | CN | 117642625 A | 01-03-2024 |
| | | | EP | 4119935 A1 | 18-01-2023 |
| | | | EP | 4370909 A1 | 22-05-2024 |
| | | | JP | 2024526714 A | 19-07-2024 |
| | | | KR | 20240028534 A | 05-03-2024 |
| | | | US | 2024255468 A1 | 01-08-2024 |
| | | | WO | 2023285966 A1 | 19-01-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **P. APPLE et al.** Nanoscale microwave imaging with a single electron spin in diamond. *New Journal of Physics*, 2015, vol. 17, 112001